# EUROPÄISCHE PATENTSCHRIFT

(11) **EP 3 186 889 B1**
(45) Veröffentlichungstag und Bekanntmachung des Hinweises auf die Patenterteilung: **03.03.2021**
(21) Anmeldenummer: 15753364.7
(22) Anmeldetag: 20.08.2015
(51) Int. Cl.: H03K 17/955, H03K 17/96

(54) **KAPAZITIVER SENSOR, DIE ZUGEHÖRIGE AUSWERTESCHALTUNG UND AKTOR FÜR EIN KRAFTFAHRZEUG**
CAPACITIVE SENSOR, THE ASSOCIATED EVALUATION CIRCUIT AND ACTUATOR FOR A MOTOR VEHICLE
CAPTEUR CAPACITIF, CIRCUIT D'INTERPRÉTATION CORRESPONDANT ET ACTIONNEUR POUR UN VÉHICULE AUTOMOBILE

(30) Priorität: 26.08.2014 DE 102014216998
(43) Veröffentlichungstag der Anmeldung: 05.07.2017
(73) Patentinhaber: IFM Electronic GmbH, 45128 Essen (DE)
(72) Erfinder: SCHULZ, Jörg, 88069 Tettnang (DE)
(86) Internationale Anmeldenummer: PCT/EP2015/069101
(87) Internationale Veröffentlichungsnummer: WO 2016/030259

(56) Entgegenhaltungen:
- EP-A1- 1 341 306
- WO-A1-2007/025785
- DE-A1-102006 020 301
- DE-A1-102007 038 225
- US-B1- 7 804 307
- ERIC Y CHOW ET AL: "A Miniature-Implantable RF-Wireless Active Glaucoma Intraocular Pressure Monitor", IEEE TRANSACTIONS ON BIOMEDICAL CIRCUITS AND SYSTEMS, IEEE, US, Bd. 4, Nr. 6, 1. Dezember 2010 (2010-12-01), Seiten 340-349, XP011336784, ISSN: 1932-4545, DOI: 10.1109/TBCAS.2010.2081364

## Beschreibung

Die Erfindung betrifft einen kapazitiven Sensor, die zugehörige Auswerteschaltung und einen Aktor für ein Kraftfahrzeug gemäß den Oberbegriffen der Patentansprüche 3, 1 und 4.

Kapazitive Sensoren sind nicht nur in der Automatisierungstechnik, sondern neuerdings auch in der Automobiltechnik weit verbreitet, wo sie u. a. als Kofferraum-, Türöffner, oder zur Sitzbelegungserkennung Anwendung finden.

Die DE 10 2012 106 526 A1 offenbart einen kapazitiven Türgriffsensor für ein Kraftfahrzeug mit mindestens zwei Elektroden mit unterschiedlichen Überwachungsbereichen, wobei eine Elektrode als Referenzelektrode (Referenzkapazität) wirkt.

Die DE 10 2012 224 007 A1 offenbart eine Anordnung und ein Verfahren zur Bestimmung der Kapazität eines Messkondensators in eine mit einem Analog-Digitalwandler erfassbare Spannung mit einer Ladungsübertragungseinrichtung zur Übertagung der Ladung einer unbekannten Kapazität Cₓ auf einen Messkondensator C_{L}, wobei allerdings nur der Vergleich einer einzigen unbekannten Kapazität Cₓ mit einer Referenzkapazität C_{ref} vorgesehen ist.

Die WO 2007 025 785 A1 offenbart eine Auswerteschaltung für kapazitive Sensoren, wobei zwei Kapazitäten miteinander verglichen werden. Zu diesem Zweck werden zwei RC-Glieder mit jeweils einem Kondensator parallel mit demselben Rechtecksignal beaufschlagt, und deren kapazitätsbedingt unterschiedliche Integrationszeiten mit Hilfe eines XOR-Phasendetektors diskriminiert. Das dabei entstehende Rechtecksignal weist ein vom Messwert abhängiges Puls-Pausenverhältnis auf, und wird mit einem weiteren RC-Glied integriert, so dass ein analoges Ausganssignal entsteht. Nachteilig ist, dass die Schaltung nicht zur Auswertung von Einzelimpulsen, sondern nur für kontinuierlichen Betreib geeignet ist.

Die AT 403 213 B offenbart einen ähnlich arbeitenden kapazitiven Bodenfeuchtesensor, bei dem eine von der zu messenden Kapazität abhängige Zeitkonstante zu einer Phasenverzerrung eines Rechtecksignals führt. Als Phasendetektor wirkt hier ein UND-Gatter, dessen Ausgangsignal einem RC-Siebglied zugeführt wird. Das RC-Siebglied wandelt das Rechtecksignal in ein von dessen Puls-Pausenverhältnis abhängiges Analogsignal um. Nachteilig ist, dass jeweils nur eine unbekannte Kapazität (Sensorelektrode) gemessen werden kann.

Schließlich offenbaren die US 7 804 307 B1 und die EP 1 341 306 A1 Multiplexverfahren für kapazitive Sensoren, die nachfolgend näher erläutert werden.

Die US 7 804 307 B1 beschreibt einen kapazitiven Sensor für berührungsempfindliche Tasten (touchpads). Hier werden ein- oder mehrere Messkondensatoren und ein Referenzkondensator mit einem konstanten Strom geladen und deren Kapazitäten durch Zählung von Oszillatorperioden (Zeitmessung) bis zum Erreichen einer bestimmten Spannung gemessen. Zur Verbesserung des Signal-Rauch-Verhältnisses werden die Kondensatoren als geschaltete Kondensatoren betrieben, indem sie ständig mit der Betriebsspannung oder Masse verbunden und damit umgeladen werden, wobei sie als Widerstände mit einem effektiven Widerstand von R = 1/(f^{∗}C_{Sensor}) aufgefasst werden können. (Spalte 4, Zeile 30).

Diese Anordnung und das Verfahren werden wegen der Umschalter und der vergleichsweise langen Einschwingzeiten als zu aufwändig angesehen.

Die EP 1 341 306 A1 beschreibt eine elektrische Schaltung für einen kapazitiven Sensor, bei dem das bereits genannte Messprinzip der geschaltete Kapazität (switched capacitor) ebenfalls zur Anwendung kommt. Auch hier werden der schaltungstechnische Aufwand und die im Absatz [0028] genannte Zeitaufwand (bei einigen tausend Ladezyklen) als nachteilig angesehen. Somit ist diese Schaltung nicht zur Auswertung von Einzelimpulsen geeignet.

Die Aufgabe der Erfindung besteht darin, eine Auswerteschaltung für einen kapazitiven Sensor anzugeben, die eine mit einem Analog-Digitalwandler erfassbare Spannung erzeugt, und zur Auswertung von mindestens zwei Sensorelektroden geeignet ist.

Darüber hinaus soll die Auswerteschaltung einfach kalibrierbar sein und mit einem minimalen Aufwand an elektronischen Bauelementen auskommen.

Die Aufgabe der Erfindung wird mit den kennzeichnenden Merkmalen des Patentanspruchs 1 gelöst. Die Unteransprüche betreffen die vorteilhafte Ausgestaltung der Erfindung.

Der wesentliche Erfindungsgedanke besteht darin, die Messkapazitäten nacheinander in einem vorgegebenen Zeitregime mit derselben Referenzkapazität zu vergleichen. Dazu wird die Referenzkapazität mit dem Eingang einer ersten Schaltstufe und die Messkapazitäten mit den Eingängen weiterer Schaltstufen verbunden, wobei diese weiteren Schaltstufen beispielsweise als NAND Gatter ausgebildet sind und Freigabeeingänge aufweisen, die vom Ausgang der ersten Schaltstufe gesteuert werden. Die Ausgänge der weiteren Schaltstufen werden jeweils mit dem Eingang einer Integrationsstufe verbunden. Über die Ausgänge der Integrationsstufen, die auch als Stromquellen wirken können, wird ein Ladekondensator geladen. Die zeitliche Länge der von den Schaltstufen generierten Ausgangsimpulse bestimmt die Spannung des Ladekondensators. In einer vorteilhaften Ausgestaltung ist die Referenzkapazität mit einer Kalibriereinheit verbunden, die mindestens einen Widerstand, einen Kondensator und eine Spannungsquelle aufweist, bzw. mit einer steuerbaren Spannungsquelle verbunden ist. Die Kalibriereinheit dient sowohl zur Verbesserung der Messgenauigkeit durch gezielte Beeinflussung der durch die Referenzkapazität erzeugten Verzögerungszeit, als auch zur zeitlichen Optimierung der Messung.

Der Vorteil der Erfindung besteht darin, dass an Stelle von mindestens 2 Kalibriereinheiten nur noch eine einzige erforderlich ist. So kann beispielsweise mit nur einem IC des Typs 74HC132 ein kapazitiver Sensor mit 3 Sensorelektroden aufgebaut werden, was einerseits zu einer Einsparung von Bauelementen führt und andererseits die Messgenauigkeit verbessert.

Die Erfindung wird anhand der Zeichnungen näher erläutert.
Fig.1 zeigt eine erfindungsgemäße Auswerteschaltung mit 3 Sensorelektroden,
Fig. 2 zeigt das Impulsdiagramm zur Steuerung der Messung im Detail.

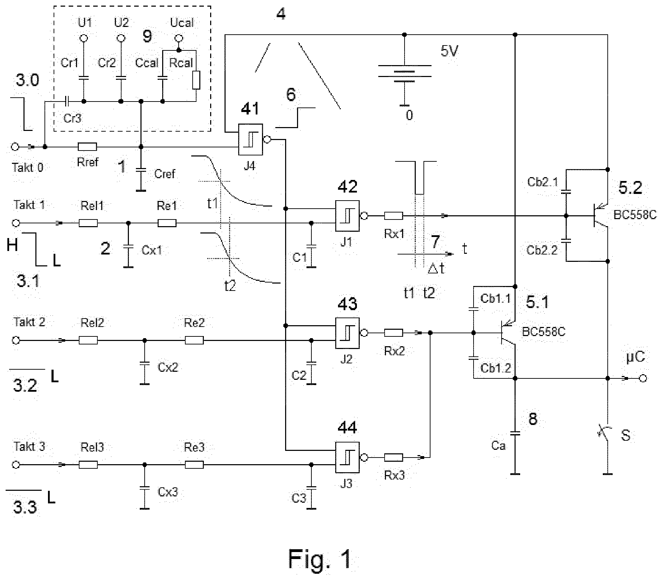

Die Fig. 1 zeigt ein Ausführungsbeispiel mit einer integrierten Schaltung des Typs 74HC132 mit insgesamt vier Schaltstufen 4 (NAND-Gatter), wobei im Ruhezustand der steuerbare Gattereingang der mit 41 bezeichneten Schaltstufe auf dem logischen Zustand "Hoch" liegt, so dass deren Ausgang den logischen Zustand "Tief" einnimmt. Das hat zur Folge, dass für die Dauer dieses Zustandes die Schaltstufen 42, 43, 44 an ihrem nicht von außen steuerbaren Eingang ebenfalls auf "Tief" liegen und somit signaltechnisch gesperrt sind, so dass deren Ausgänge für die Dauer dieses Signalzustandes auf "Hoch" liegen und die Integrationsstufen 5 ebenfalls gesperrt sind, und der vorher von dem oben genannten Mikrocontroller µC gesteuerte Schalter S entladene, hier mit 8 bezeichnete Ladekondensator Cₐ entladen bleibt.

Der nicht mit der Betriebsspannung verbundene Steuereingang der Schaltstufe 41 ist mit einer Kalibriereinheit verbunden, die neben Rref und C_{ref} einen Kalibrierwiderstand R_{cal} und einen Kondensator C_{cal} aufweist. Darüber hinaus sind über die Kondensatoren Cᵣ₁ und Cᵣ₂ zwei Hilfsspannungsquellen U₁ und U₂ angeschlossen.

Im Ruhezustand liegt einer der Takteingänge Takt 1, Takt 2, Takt 3 auf "Hoch", die beiden anderen Takteingänge liegen auf "Tief". Damit wird die Schaltstufe 42, deren Takteingang auf "Hoch" liegt, für eine Impulserzeugung vorbereitet, während die beiden anderen Takteingänge während dieser Impulserzeugung durch das logische Eingangssignal "Tief" weiterhin gesperrt bleiben.

Zur Erzeugung eines Impulses an einem der Ausgänge der Schaltstufen 42, 43, 44 werden durch eine extern angeschlossene, hier nicht dargestellte Steuereinheit, z.B. einen Mikrocontroller (µC) , sowohl der Takteingang "Takt 0" als auch der auf "Hoch" liegende Takteingang von den Takteingängen Takt 1, Takt 2, Takt 3 gleichzeitig auf "Tief" geschaltet. Dadurch gelangt das an "Takt 0" angelegte Signal über den Tiefpass R_{ref}, C_{ref} an den Eingang des betreffenden NAND Gatters 41 und löst bei Erreichen der Schwellspannung an dessen Ausgang einen positiven Spannungssprung aus, wobei die Verzögerungszeit in starkem Maße von der Kalibriereinheit beeinflusst wird, mit deren Hilfe das Signal an C_{ref} zeitlich verschoben und in seinem Verlauf beeinflusst werden kann. Zu diesem Zweck wird die Spannung U_{cal} und die Hilfsspannungen U₁ und U₂ angelegt. Diese Spannungen und auch die vier gezeigten Taktsignale (Takt 0, Takt 1, Takt 2, Takt 3) können von der zuvor beschriebenen Steuereinheit (µC) erzeugt werden.

Für eine sinnvolle Impulserzeugung sind alle Zeitkonstanten und alle Steuersignale, die signaltechnisch vor den Gattereingängen der Gatter 41 und 42, 43, 44 liegen, so dimensioniert, beziehungsweise eingestellt, dass zuerst die Spannung am Gattereingang des Gatters 41 seine negative Schaltschwelle erreicht. Dies bewirkt, dass an allen von außen nicht zugänglichen Gattereingängen der Gatter 42, 43, 44 der logische Zustand von "Tief" auf "Hoch" wechselt, so dass wie gezeigt, das Gatter 42, an dessen von außen zugänglichem Eingang der logische Zustand "Hoch" anliegt, seinen Ausgang auf "Tief" schaltet und somit eine nachfolgend angeschlossene Integrationsstufe 5 ansteuert. Damit wird ein Ladevorgang des mit 8 bezeichneten Kondensators Cₐ über eine der Integrationsstufen 5 gestartet. Die beiden anderen Gatter 43 und 44, an denen die von außen zugänglichen Eingänge weiterhin auf "Tief" liegen, bleiben damit signaltechnisch gesperrt.

Danach erreicht die Spannung an dem von außen zugänglichen Gattereingang, dessen angeschlossener Takteingang gleichzeitig mit dem Signal "Takt 0" von "Hoch" auf "Tief" geschaltet wird, seine negative Schaltschwelle, so dass der soeben von "Hoch" auf "Tief" geschaltete Gatterausgang wieder auf "Hoch" zurück schaltet und somit die Ansteuerung der nachfolgend angeschlossenen Integrationsstufe 5.1 oder 5.2 wieder unterbricht, wodurch der Ladevorgang des mit 8 bezeichneten Kondensators Cₐ beendet wird.

Somit wird bei Erreichen der Schwellspannung einer ersten Schaltstufe (41) ein Startsignal und bei Erreichen der Schwellspannung einer zweiten Schaltstufe (42, 43, 44) ein Stoppsignal erzeugt.

Die Referenzkapazität 1 ist mit einer Kalibriereinheit 9 zur gezielten Beeinflussung der durch die Referenzkapazität 1 erzeugten Verzögerungszeit verbunden, wobei die Kalibriereinheit 9 mindestens einen Widerstand R_{cal}, einen Kondensator C_{cal} und eine von der Auswerteeinheit (µC) steuerbare Spannungsquelle U_{cal} aufweist.

Damit ist die Zeitdauer der Ansteuerung der Integrationsstufen 5.1 und 5.2 abhängig von der zu messenden Elektrodenkapazität, welche dem jeweils aktivierten Takteingang (Takt 1, Takt 2, Takt 3) zugeordnet ist. Zur Auswertung einer beliebigen zu messenden Kapazität wird der jeweils zugeordnete Takteingang in der oben beschriebenen Weise angesteuert.

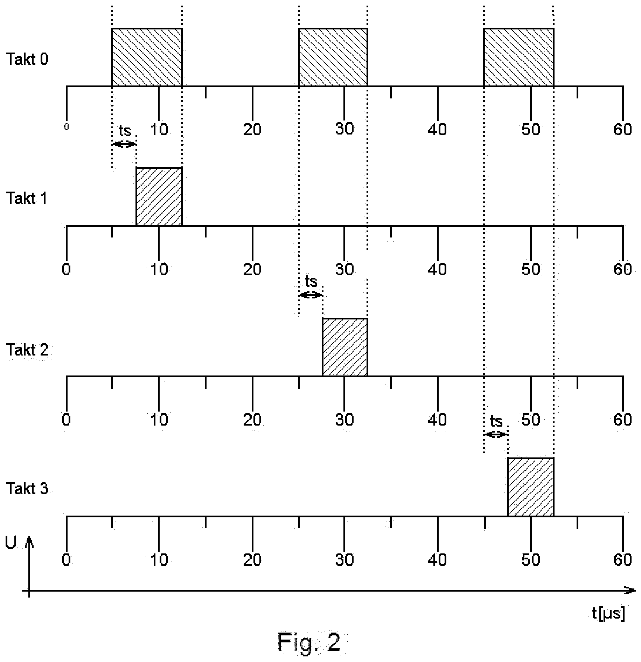

Die Fig. 2 zeigt das zugehörige Impulsdiagramm im Detail. Die Signale entsprechen den Takten aus Fig. 1. Man erkennt die in der Fig. 1 nicht dargestellten, zeitlich verzögerten, für die Gatter 43 und 44 bestimmten Takte 2 und 3.

Die mit "ts" bezeichnete Zeitspanne dient zur Herstellung eines definierten Initialzustandes und muss mindestens so groß sein wie die Summe sämtlicher Verzögerungszeiten, die Einfluss auf das elektrische Potential der relevanten Kapazitäten haben können, und sorgt so für einen reproduzierbaren Ablauf der Messung.

### Bezugszeichen

- 1: Referenzkapazität,
- 2: Messkapazität(en), Messelektrode(n)
- 3: (3.0 bis 3.3) Rechteckspannungen, Taktsignale
- 4: Schaltstufen, (41, 42, 43, 44): NAND-Gatter 74HC132 mit Schmitt Trigger
- 5: (5.1 und 5.2) Integrationsstufen (Bipolarer Miller-Integrator bzw. Stromquelle)
- 6: Steuersignal für die von außen nicht zugänglichen Gattereingänge (42, 43, 44)
- 7: Impulsdauer (Δt) , repräsentiert den Messwert
- 8: Ladekondensator, Integrationskondensator
- 9: Kalibriereinheit, bestehend aus R_{cal}, C_{cal} und U_{cal} (für alle Messelektroden)

## Patentansprüche

1. Auswerteschaltung für einen kapazitiven Sensor zur Erfassung des Abstands, der Geschwindigkeit oder der Position eines Objekts, mit einer Referenzkapazität (1) und zwei Messkapazitäten (2), wobei die Referenzkapazität (1) und die Messkapazitäten (2) über je einen Widerstand (Rref, Rel1, Rel2) mit je einer Rechteckspannung (Takt0-Takt2) beaufschlagt werden und mit Hilfe von einer ersten Schaltstufe (41) und von weiteren Schaltstufen (42, 43, 44) ein zeitdauervariabler Impuls (7) gewonnen wird, der ein Maß für die jeweilige Messkapazität (2) darstellt, die Referenzkapazität (1) mit dem Eingang der ersten Schaltstufe (41) verbunden ist, wobei jede Messkapazität (2) mit dem Eingang einer jeweils weiteren Schaltstufe (42, 43) verbunden ist, wobei die weiteren Schaltstufen (42, 43) Freigabeeingänge aufweisen, die vom Ausgang der ersten Schaltstufe (41) gesteuert werden, wobei die Ausgänge der weiteren Schaltstufen (42, 43) jeweils mit Eingängen von Integrationsstufen (5a, 5b) verbunden sind, wobei über die Ausgänge der Integrationsstufen (5a, 5b) ein Ladekondensator (8) geladen wird, wobei die Schaltstufen (41-43) Schwellspannungen aufweisen und bei Erreichen der Schwellspannung der ersten Schaltstufe (41) ein Startsignal für den Ladevorgang des Ladekondensators (8) und bei Erreichen der Schwellspannung einer weiteren Schaltstufe (42, 43) ein Stoppsignal für den Ladevorgang des Ladekondensators (8) erzeugt wird.

2. Auswerteschaltung für einen kapazitiver Sensor nach Anspruch 1, **dadurch gekennzeichnet, dass** die Referenzkapazität (1) mit einer Kalibriereinheit (9) zur gezielten Beeinflussung der durch die Referenzkapazität (1) erzeugten Verzögerungszeit verbunden ist, wobei die Kalibriereinheit (9) mindestens einen Widerstand, einen Kondensator und eine von der Auswerteeinheit µC steuerbare Spannungsquelle aufweist.

3. Kapazitiver Sensor mit einer Auswerteschaltung nach Anspruch 1 oder 2.

4. Mit einem kapazitiven Sensor nach Anspruch 3 verbundenen Aktor in einem Kraftfahrzeug.

5. Aktor nach Anspruch 4 zur Betätigung eines Türgriffs in einem Kraftfahrzeug.

## Claims

1. Evaluation circuit for a capacitive sensor for recording the distance, the speed or the position of an object, having a reference capacitance (1) and two measuring capacitances (2), wherein the reference capacitance (1) and the measuring capacitances (2) have a respective square-wave voltage (Takt0-Takt2) applied thereto via a respective resistor (Rref, Rel1, Rel2) and a variable-duration pulse (7) is obtained using a first switching stage (41) and further switching stages (42, 43, 44), which variable-duration pulse constitutes a measure of the respective measuring capacitance (2), the reference capacitance (1) is connected to the input of the first switching stage (41), wherein each measuring capacitance (2) is connected to the input of a respective further switching stage (42, 43), wherein the further switching stages (42, 43) have enable inputs that are controlled by the output of the first switching stage (41), wherein the outputs of the further switching stages (42, 43) are connected in each case to inputs of integration stages (5a, 5b), wherein a charging capacitor (8) is charged via the outputs of the integration stages (5a, 5b), wherein the switching stages (41-43) have threshold voltages and, when the threshold voltage of the first switching stage (41) is reached, a start signal for starting the charging process of the charging capacitor (8) is generated and, when the threshold voltage of a further switching stage (42, 43) is reached, a stop signal for stopping the charging process of the charging capacitor (8) is generated.

2. Evaluation circuit for a capacitive sensor according to Claim 1, **characterized in that** the reference capacitance (1) is connected to a calibration unit (9) for influencing the delay time, generated by the reference capacitance (1), in a targeted manner, wherein the calibration unit (9) has at least a resistor, a capacitor and a voltage source able to be controlled by the evaluation unit µC.

3. Capacitive sensor having an evaluation circuit according to Claim 1 or 2.

4. Actuator, connected to a capacitive sensor according to Claim 3, in a motor vehicle.

5. Actuator according to Claim 4 for actuating a door handle in a motor vehicle.

## Revendications

1. Circuit d'évaluation pour un capteur capacitif, pour détecter la distance, la vitesse ou la position d'un objet, comprenant une capacité de référence (1) et deux capacités de mesure (2), la capacité de référence (1) et les capacités de mesure (2) étant sollicitées par le biais d'une résistance respective (Rref, Re11, Re12) avec une tension rectangulaire respective (Temps0-Temps2) et une impulsion variable dans le temps (7) étant obtenue à l'aide d'un premier étage de commutation (41) et d'étages de commutation supplémentaires (42, 43, 44), laquelle représente une mesure de la capacité de mesure respective (2), la capacité de référence (1) étant connectée à l'entrée du premier étage de commutation (41), chaque capacité de mesure (2) étant connectée à l'entrée d'un étage de commutation supplémentaire respectif (42, 43), les étages de commutation supplémentaires (42, 43) présentant des entrées d'activation qui sont commandées depuis la sortie du premier étage de commutation (41), les sorties des étages de commutation supplémentaires (42, 43) étant chacune connectées aux entrées d'étages d'intégration (5a, 5b), un condensateur de charge (8) étant chargé par le biais des sorties des étages d'intégration (5a, 5b), les étages de commutation (41-43) présentant des tensions de seuil, et à l'obtention de la tension de seuil du premier étage de commutation (41), un signal de départ étant généré pour l'opération de charge du condensateur de charge (8), et à l'obtention de la tension de seuil d'un étage de commutation supplémentaire (42, 43), un signal d'arrêt étant généré pour l'opération de charge du condensateur de charge (8).

2. Circuit d'évaluation pour un capteur capacitif selon la revendication 1, **caractérisé en ce que** la capacité de référence (1) est connectée à une unité d'étalonnage (9) pour influencer de manière ciblée le temps de retard généré par la capacité de référence (1), l'unité d'étalonnage (9) présentant au moins une résistance, un condensateur et une source de tension pouvant être commandée par l'unité d'évaluation µC.

3. Capteur capacitif comprenant un circuit d'évaluation selon la revendication 1 ou 2.

4. Actionneur connecté à un capteur capacitif selon la revendication 3, dans un véhicule automobile.

5. Actionneur selon la revendication 4, pour l'actionnement d'une poignée de porte dans un véhicule automobile.
